Europäisches Patentamt

European Patent Office

Office européen des brevets

(11) Publication number: **0 299 675**
**A2**

# EUROPEAN PATENT APPLICATION

(21) Application number: 88306194.7

(22) Date of filing: 07.07.88

(51) Int. Cl.⁴: **H03L 7/08**

(30) Priority: 11.07.87 GB 8716387

(43) Date of publication of application:
18.01.89 Bulletin 89/03

(84) Designated Contracting States:
DE FR IT SE

(71) Applicant: **PLESSEY OVERSEAS LIMITED**
**Vicarage Lane**
**Ilford Essex IGI 4AQ(GB)**

(72) Inventor: **Cowley, Nicholas Paul**
**10 Summerhouse Road**
**Wroughton Wiltshire(GB)**

(74) Representative: **Elliott, Frank Edward**
**The Plessey Company plc. Intellectual**
**Property Department Vicarage Lane**
**Ilford, Essex IG1 4AQ(GB)**

(54) Improvements in or relating to phase locked loop circuits.

(57) A phase locked loop circuit is provided in which the loop gain of the circuit is controlled in dependence upon the frequency of the local oscillator to linearize the response of the circuit to varying frequency.

EP 0 299 675 A2

## IMPROVEMENTS IN OR RELATING TO PHASE LOCKED LOOP CIRCUITS

This invention relates to phase locked loop circuits, for incorporation into, for example, a frequency synthesiser of a receiver, the phase locked loop having at least one phase detector.

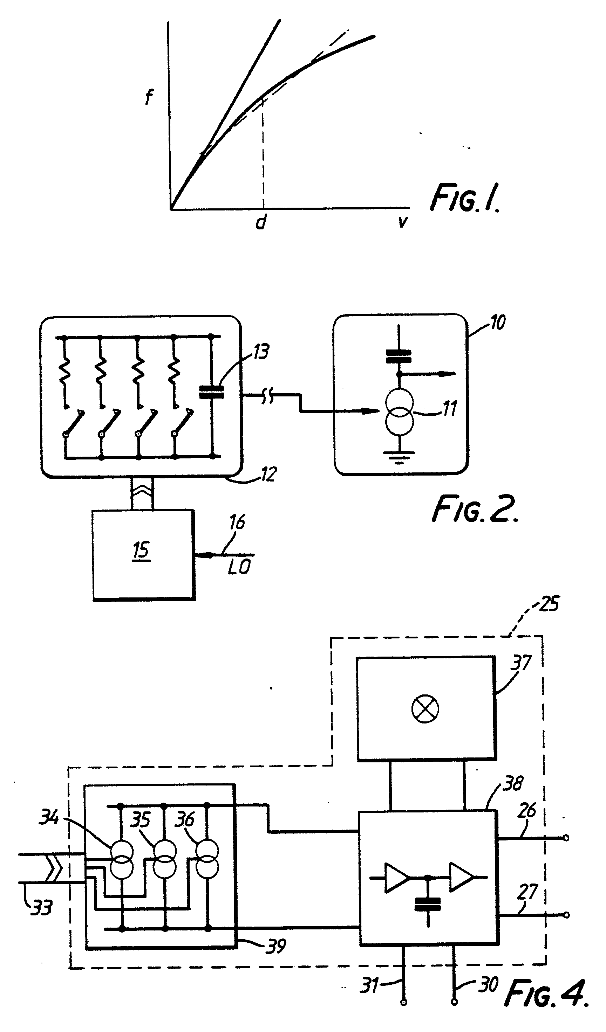

PLL (Phase Locked Loop) circuits include a signal source, generally a local oscillator, a reference source, a phase detector for comparing the phases of signals from the signal source and the reference source and for providing an output signal in dependance upon phase differences in the signals, and a means for varying the frequency of signals from the signal source in dependance on the phase difference signal. The means for varying the frequency of signals from the signal source is generally a varactor i.e. a voltage dependant capacitor such as a diode. Diode varactors, unfortunately do not have a linear output characteristic. Figure 1 of the accompanying drawings is a graphical representation illustrating how the frequency of an oscillator including a diode varactor varies in dependance upon the voltage applied thereto. A consequent difficulty occasioned by this non-linearity is that loop parameters such as loop-settling times cannot be predicted as loop performance varies from optimum in accordance with the above-stated non-linearity.

In order to improve linearity and to define an optimum operating characteristic, it is conventional to "centre" the response of the local oscillator, the signal source, for example, as indicated at point d of the graph of Figure 1. To do this, a control means is provided externally of the phase detector. As shown in Figure 2, a loop amplifier 10 of the phase detector includes a controllable current source 11 and an external control means 12 forming a feedback loop of the amplifier. The control means 12 normally includes a presettable resistor arrangement and may also include a capacitor.

In one known attempt at optimising loop performance, this external control means 12 includes a plurality of resistors switchable into and out of the feedback loop of the loop amplifier 10 under the control of a microprocessor 15 having a control input 16 indicative of the frequency of the local oscillator or signal source. However, the additional external (off-chip) circuitry introduces considerable noise and this, and the increased cost, have mitigated against such a solution.

It is an object of the present invention to provide a phase locked loop circuit wherein loop gain is effectively controlled to overcome the disadvantage of non-linearity of response but wherein the aforesaid external noise is minimised.

According to the present invention, there is provided a phase locked loop circuit including a phase detector, variable current source controlling the gain of a loop amplifier of the phase detector, a programmable data register the output of which sets the variable current source, and control means for controlling the output of the data register.

The variable current source may comprise a plurality of ratioed current sources.

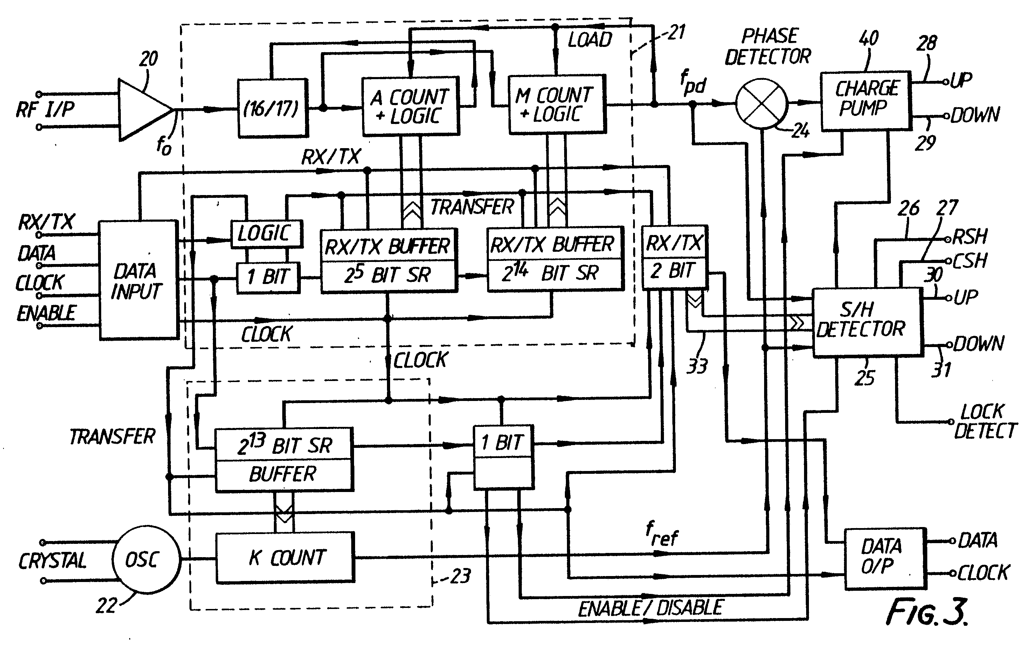

The invention will be described further, by way of example, with reference to Figures 3 and 4 of the accompanying drawings, in which:-

Figure 3 is a schematic block diagram of phase locked loop circuit in accordance with the present invention; and,

Figure 4 is a schematic diagram of a part of the phase locked loop circuit shown in Figure 3.

Figure 3 shows, schematically, that part of a phase locked loop circuit, for a transmitter receiver, which may be integrated on a single chip. Various advantageous parts of the circuit are described in more detail in our copending patent application Nos.

filed simultaneously herewith. The circuit comprises a buffer amplifier 20 whereto the output of an off-chip local oscillator (not shown) may be fed. The output of the amplifier 20, a signal at frequency $f_c$, is fed to a divide-by-N programmable divider 21 which provides an output at a frequency $f_{PD}$. An off-chip crystal (not shown) forms part of a reference oscillator 22, the output of which is fed to a divide-by-K programmable divider 23 providing a stable reference signal of frequency $f_{ref}$. The signals of frequency $f_{PD}$ and $f_{ref}$ are fed to a digital phase detector 24 and to an analogue sample-and-hold phase detector 25 in which the phase of the signals are compared. The detectors 24 and 25 each provide $\phi_{up}$ and $\phi_{down}$ signals at nodes 28, 29 and 30, 31 which signals are used, separately or together to control a varactor (not shown) forming part of the local oscillator to vary the frequency $f_0$ of such oscillator thereby establishing the phase locked loop circuit.

As mentioned above, it is conventional to provide, off-chip, an external control means (not shown). Nodes 26 and 27 provide access to the chip from such control means. The input from the control means serves to control the gain of a loop amplifier provided in the sample-and-hold phase detector 25 to establish, initially, a master gain unit of the loop.

In accordance with the present invention, the phase locked loop circuit also includes a programmable data register 32 the output 33 of which controls a plurality of ratioed current sources 34 to 36 in the loop amplifier of the sample-and-hold phase detector 25. The register 32 has inputs de-

pendant upon the value $f_o$ and works in conjunction with the Rx/Tx buffer of the programmable divider 21 so that a logic bit of the programmable divider 21 indicates the mode of the transmitter/receiver.

The data register 32 is shown as a two bit register thereby providing four output states. As shown in Figure 4, the loop amplifier of the sample-and-hold detector 25 has three current sources 34, 35 and 36 controlling the gain of the amplifier. The detector 25 comprises the phase detector 37 per se, the loop amplifier 38 and a current source 39 comprising the three ratioed and register-controlled current sources 34, 35 and 36. High and low states of the two bit output by the data register 32 control which of the current sources 34, 35 and 36 provide current and thereby the gain of the loop amplifier about the preset value defined by the inputs at nodes 30 and 31, in turn defined by the external gain control means.

The invention is not confined to the details given above. For example the data register may control the output of the digital phase detector 24 or the charge pump 40 or a separate data register may be provided for each detector, the data register being appropriately enabled and disabled as required.

Whilst the foregoing description has described only relevant parts of the phase locked loop circuit of a transmitter/receiver in detail, other parts are of a nature well-known to those skilled in the arts. It will be appreciated also that the invention is applicable to any apparatus embodying a phase locked loop circuit such as a frequency synthesiser forming part of an apparatus other than a transmitter/receiver.

## Claims

1. A phase locked loop circuit including a phase detector, a variable current source controlling the gain of a loop amplifier of the phase detector, a programmable data register the output of which sets the variable current source, and control means for controlling the output of the data register.

2. A circuit as claimed in claim 1 wherein the variable current source comprises a plurality of ratioed current sources.

3. A circuit as claimed in claim 1 or 2 wherein the data register is a 2 bit register.

4. A circuit as claimed in claim 1, 2, or 3 wherein the data register comprises Rx and Tx buffers, the buffers being selectable in accordance with the operational mode of the circuit.

5. A circuit as claimed in any of claims 1 to 4 wherein the control means is dependent upon the value of the frequency $f_o$ of a local oscillator associated with the circuit.

6. A phase locked loop circuit substantially as hereinbefore described with reference to and as illustrated in Figures 3 and 4 of the accompanying drawings.

**FIG. 1.**

**FIG. 2.**

**FIG. 4.**

**Fig.3.**

RF I/P

20

$f_0$

21

(16/17)

A COUNT + LOGIC

M COUNT + LOGIC

LOAD

$f_{pd}$

24

PHASE DETECTOR

CHARGE PUMP

40

28 — UP

29 — DOWN

RX/TX

DATA

CLOCK

ENABLE

DATA INPUT

LOGIC

1 BIT

RX/TX BUFFER 25 BIT SR

RX/TX BUFFER $2^{14}$ BIT SR

TRANSFER

RX/TX 2 BIT

33

S/H DETECTOR

25

26 — RSH

27 — CSH

30 — UP

31 — DOWN

LOCK DETECT

CLOCK

CLOCK

RX/TX

1 BIT

$2^{13}$ BIT SR BUFFER

TRANSFER

$f_{ref}$

ENABLE / DISABLE

DATA O/P

DATA

CLOCK

OSC

K COUNT

23

22

CRYSTAL